(19) Europäisches Patentamt
European Patent Office
Office européen des brevets

(11) **EP 3 375 549 A1**

(12) **EUROPEAN PATENT APPLICATION**

(43) Date of publication:
**19.09.2018 Bulletin 2018/38**

(51) Int Cl.:
**B22F 3/105** *(2006.01)*    **B23K 26/00** *(2014.01)*
**B29C 67/04** *(2017.01)*    **C04B 35/64** *(2006.01)*

(21) Application number: **18158434.3**

(22) Date of filing: **23.02.2018**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD TN**

(30) Priority: **15.03.2017 JP 2017050365**

(71) Applicant: **KABUSHIKI KAISHA TOSHIBA**
**Minato-ku**
**Tokyo**
**105-8001 (JP)**

(72) Inventors:
• **Shiomi, Yasutomo**
 **Tokyo, 105-8001 (JP)**
• **Okada, Naotada**
 **Tokyo, 105-8001 (JP)**
• **Yamada, Tomohiko**
 **Tokyo, 105-8001 (JP)**
• **Sasaki, Mitsuo**
 **Tokyo, 105-8001 (JP)**
• **Ohno, Hiroshi**
 **Tokyo, 105-8001 (JP)**

(74) Representative: **Henkel, Breuer & Partner**
**Patentanwälte**
**Maximiliansplatz 21**
**80333 München (DE)**

(54) **ADDITIVE MANUFACTURING APPARATUS, PROCESSING DEVICE, AND ADDITIVE MANUFACTURING METHOD**

(57)    According to an arrangement, an additive manufacturing apparatus (1) includes a first irradiation unit (42), and a first emission device (41). The first irradiation unit (42) is configured to irradiate a material (3) with first light (L1) to melt or sinter the material (3). The first emission device (41) includes a first light source (41a) configured to emit the first light (L1), is configured to cause the first light (L1) emitted from the first light source (41a) to enter the first irradiation unit (42), and is capable of changing a wavelength of the first light (L1) entering the first irradiation unit (42).

FIG.1

## Description

FIELD

The present disclosure relates to an additive manufacturing apparatus, a processing device, and an additive manufacturing method.

BACKGROUND

Additive manufacturing apparatuses have been known that irradiate a material with laser light to solidify the material and form a layer of the solidified material. The layers of the solidified material are laminated. As a result, a three-dimensional manufactured product is formed by additive manufacturing.

BRIEF DESCRIPTION OF THE DRAWINGS

FIG. 1 is a schematic diagram schematically illustrating an additive manufacturing apparatus according to a first arrangement;

FIG. 2 is a cross-sectional view illustrating a nozzle in the first arrangement and an object;

FIG. 3 is a graph illustrating exemplary spectral distributions of first light detected by a first photo detector and a second photo detector in the first arrangement;

FIG. 4 is a schematic diagram schematically illustrating an exemplary procedure of manufacturing processing by the additive manufacturing apparatus in the first arrangement;

FIG. 5 is a graph illustrating an example of a spectral transmittance of a first material in the first arrangement;

FIG. 6 is a graph illustrating an example of a spectral transmittance of a second material in the first arrangement;

FIG. 7 is a graph illustrating a part of the spectral transmittance of the material in the first arrangement, and exemplary spectral distributions of the first light and second light;

FIG. 8 is a graph illustrating examples of an adjusted peak curve, and a first derivative and a second derivative of the adjusted peak curve in the first arrangement;

FIG. 9 is a cross-sectional view schematically illustrating a part of a manufactured product in the first arrangement;

FIG. 10 is a flowchart illustrating an example of adjusted peak curve selection processing in the first arrangement;

FIG. 11 is a schematic diagram schematically illustrating the additive manufacturing apparatus according to a second arrangement;

FIG. 12 is a cross-sectional view illustrating the nozzle according to a third arrangement and the object; and

FIG. 13 is a schematic diagram schematically illustrating a first emission device and a first optical system in a fourth arrangement.

DETAILED DESCRIPTION

According to an arrangement, an additive manufacturing apparatus includes a first irradiation unit, and a first emission device. The first irradiation unit is configured to irradiate a material with first light to melt or sinter the material. The first emission device includes a first light source configured to emit the first light, is configured to cause the first light emitted from the first light source to enter the first irradiation unit, and is capable of changing a wavelength of the first light entering the first irradiation unit.

First arrangement

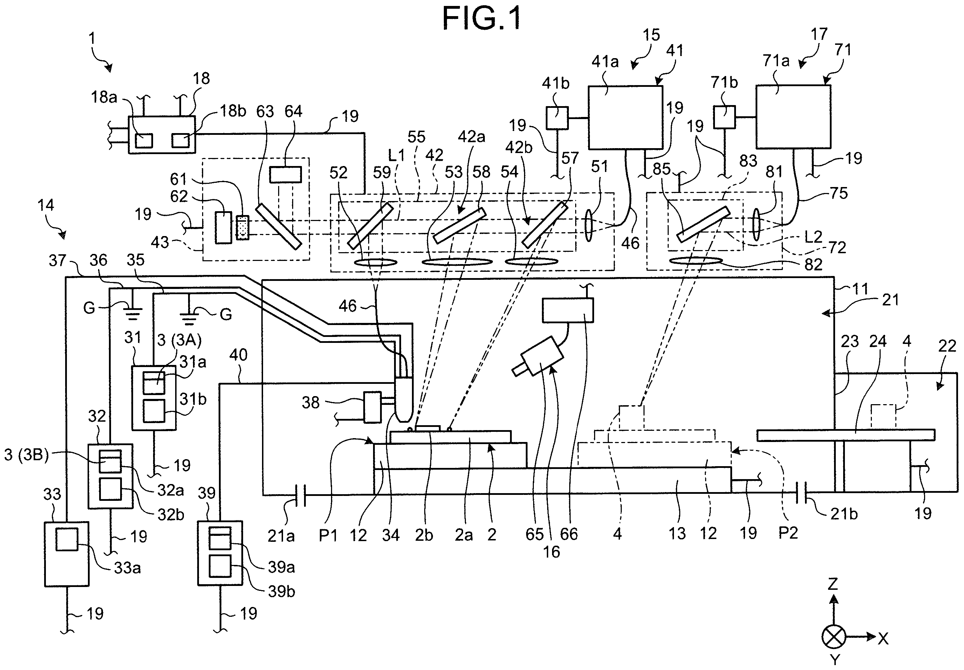

The following describes a first arrangement with reference to FIGS. 1 to 10. In the present specification, basically, the direction upward in the vertical direction is defined as an upward direction while the direction downward in the vertical direction is defined as a downward direction. The constituent elements in the arrangement and the explanations thereof may be described by a plurality of expressions. Any expressions of the constituent elements and explanations thereof other than the expressions described herein are applicable. In addition, any expressions of the constituent elements and explanations thereof, which are not described by multiple expressions, other than the expressions described herein are applicable.

FIG. 1 is a schematic diagram schematically illustrating an additive manufacturing apparatus 1 according to the first arrangement. The additive manufacturing apparatus 1 in the first arrangement is a three-dimensional printer using laser material deposition. The additive manufacturing apparatus 1, however, is not limited to this example.

The additive manufacturing apparatus 1 forms a manufactured product 4 having a certain shape by additive manufacturing that layers a powdered material 3 on an object 2. The object 2 and the material 3 are examples of the object. As illustrated in FIG. 1, the additive manufacturing apparatus 1 includes a processing tank 11, a stage 12, a moving device 13, a nozzle device 14, a first optical device 15, a measurement device 16, a second optical device 17, a control device 18, and a plurality of signal lines 19.

As illustrated in the respective figures, the X axis, the Y axis, and the Z axis are defined in the specification. The X, Y, and Z axes are orthogonal to one another. The Z axis is along the vertical direction, for example. The additive manufacturing apparatus 1 may be disposed in such a manner that the Z axis is tilted from the vertical direction.

The material 3 is supplied by the nozzle device 14 and layered on the object 2. The material 3 is a powdered thermoplastic resin, for example. The material 3 is not limited to the thermoplastic resin. The material 3 may be any of materials such as other synthetic resins, metals, and ceramics.

In the first arrangement, the additive manufacturing apparatus 1 forms the manufactured product 4 by additive manufacturing using two kinds of materials 3. The material 3 includes a first material 3A and a second material 3B, which are different from each other. The first material 3A is an acrylonitrile butadiene styrene (ABS) resin, for example. The second material 3B is polystyrene, for example. The additive manufacturing apparatus 1 may form the manufactured product 4 using a single kind of material 3 or two or more kinds of materials 3. The first material 3A and the second material 3B may be another material such as nylon, for example.

The object 2 serves as the object to which the material 3 is supplied by the nozzle device 14. The object 2 includes a base 2a and a layer 2b. The base 2a is made of the same material as the first material 3A or the second material 3B, for example. The base 2a may be made of another material. The base 2a is formed in a plate shape and disposed on the stage 12. The layer 2b is made of the material 3 supplied by the nozzle device 14 and layered on the top surface of the base 2a.

The processing tank 11 is provided with a main chamber 21 and a sub chamber 22. In the main chamber 21, the stage 12, the moving device 13, a part of the nozzle device 14, and the measurement device 16 are arranged. The sub chamber 22 is disposed adjacent to the main chamber 21.

Between the main chamber 21 and the sub chamber 22, a door unit 23 is disposed. When the door unit 23 is open, the main chamber 21 and the sub chamber 22 communicate with each other while when the door unit 23 is closed, the main chamber 21 and the sub chamber 22 are separated from each other. When the door unit 23 is closed, the main chamber 21 may be in an airtightly sealed state.

The main chamber 21 is provided with an air intake vent 21a and an air exhaust vent 21b. For example, an air supply device located outside the processing tank 11 supplies an inert gas such as nitrogen or argon into the main chamber 21 through the air intake vent 21a. For example, an air exhaust device located outside the processing tank 11 sucks a gas from the main chamber 21 through the air exhaust vent 21b and discharges the gas. The additive manufacturing apparatus 1 may keep the main chamber 21 under vacuum by discharging the gas in the main chamber 21 through the air exhaust vent 21b.

From the main chamber 21 to the sub chamber 22, a transfer device 24 is disposed. The transfer device 24 transfers the manufactured product 4 processed in the main chamber 21 into the sub chamber 22. The sub chamber 22, thus, houses the manufactured product 4 processed in the main chamber 21. After the sub chamber 22 houses the manufactured product 4, the door unit 23 is closed. As a result, the sub chamber 22 and the main chamber 21 are separated from each other.

The stage 12 supports the object 2. The stage 12 supports the manufactured product 4 formed by the additive manufacturing. The moving device 13 moves the stage 12 in three axial directions orthogonal to one another, for example. The moving device 13 may rotate the stage 12 around two axial directions orthogonal to each other. The moving device 13 moves the stage 12 to a manufacturing position P1 illustrated with the solid line in FIG. 1 and a polishing position P2 illustrated with the chain double-dashed line in FIG. 1, for example.

The nozzle device 14 supplies the material 3 to the object 2 positioned on the stage 12. The supplied material 3 and the object 2 positioned on the stage 12 are irradiated with first light L1 emitted from the nozzle device 14. In the first arrangement, the first light L1 is laser light.

The nozzle device 14 can supply the first material 3A and the second material 3B in parallel with each other or selectively supply one of the first material 3A and the second material 3B. The first light L1 is emitted from the nozzle device 14 in parallel with the supply of the material 3. The first light L1 can also be described as energy rays. The nozzle device 14 may emit not only laser light but also other energy rays. Any energy rays are applicable that can melt or sinter the material in the same manner as the laser light. Examples of such energy rays include electron beams and electromagnetic waves in a range from a microwave region to an ultraviolet ray region.

The nozzle device 14 includes a first material supply device 31, a second material supply device 32, a gas supply device 33, a nozzle 34, a first supply pipe 35, a second supply pipe 36, a gas supply pipe 37, and a moving mechanism 38. The first supply pipe 35 and the second supply pipe 36 are examples of the neutralization unit.

The first material supply device 31 sends the first material 3A to the nozzle 34 through the first supply pipe 35. The second material supply device 32 sends the second material 3B to the nozzle 34 through the second supply pipe 36. The gas supply device 33 sends a gas to the nozzle 34 through the gas supply pipe 37.

The first material supply device 31 includes a tank 31a and a supply unit 31b. The tank 31a houses the first material 3A. The supply unit 31b supplies the first material 3A in the tank 31a to the nozzle 34 through the first supply pipe 35. The supply unit 31b supplies the first material 3A to the object 2 through the nozzle 34.

The first supply pipe 35 removes charge from the first material 3A supplied by the supply unit 31b. The first supply pipe 35 is made of metal, for example. The first supply pipe 35, which is earthed to the ground G, can remove charge from the first material 3A in contact with the first supply pipe 35. Charge may be removed from the first material 3A by other methods.

The second material supply device 32 includes a tank 32a and a supply unit 32b. The tank 32a houses the second material 3B. The supply unit 32b supplies the second material 3B in the tank 32a to the nozzle 34 through the second supply pipe 36. The supply unit 32b supplies the second material 3B to the object 2 through the nozzle 34.

The second supply pipe 36 removes charge from the second material 3B supplied by the supply unit 32b. The second supply pipe 36 is made of metal, for example. The second supply pipe 36, which is earthed to the ground G, can remove charge from the second material 3B in contact with the second supply pipe 36. The neutralization unit may remove charge from the second material 3B by other methods.

The gas supply device 33 includes a gas supply unit 33a. The gas supply device 33 supplies a shield gas (gas) to the nozzle 34. The shield gas is an inert gas such as nitrogen or argon, for example. When the main chamber 21 is kept under vacuum, the nozzle device 14 may not include the gas supply device 33.

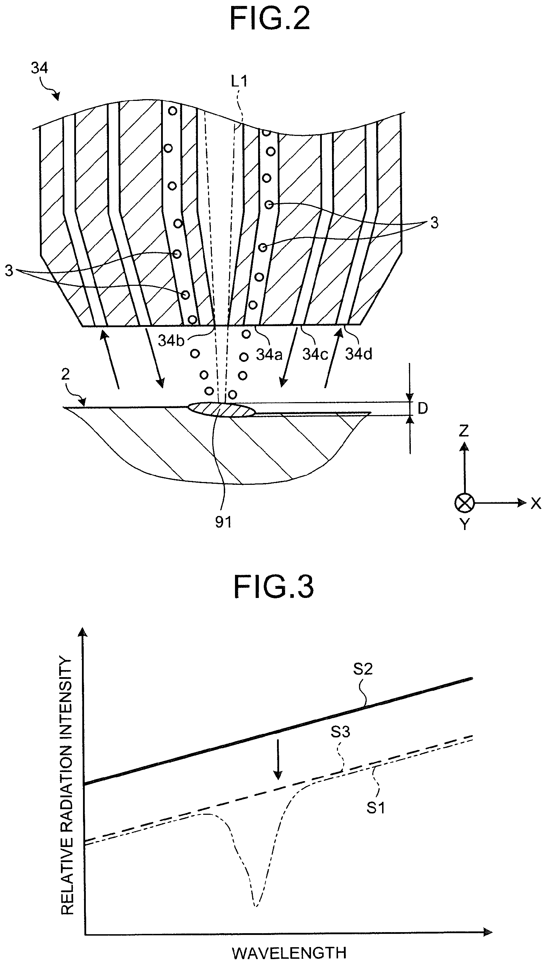

The nozzle 34 is disposed in the main chamber 21. FIG. 2 is a cross-sectional view illustrating the nozzle 34 in the first arrangement and the object 2. As illustrated in FIG. 2, the nozzle 34 is formed in a tubular shape and faces the object 2. The nozzle 34 is provided with a first ejection port 34a, an emission port 34b, a second ejection port 34c, and an exhaust port 34d.

The first ejection port 34a surrounds the emission port 34b, and communicates with the first supply pipe 35 and the second supply pipe 36. The first material 3A and the second material 3B are, thus, supplied to the object 2 from the first ejection port 34a of the nozzle 34. The first light L1 is emitted through the emission port 34b. The second ejection port 34c surrounds the first ejection port 34a, and communicates with the gas supply pipe 37. The shield gas is, thus, supplied to the object 2 from the second ejection port 34c.

As illustrated in FIG. 1, the nozzle device 14 further includes an exhaust device 39 and an exhaust pipe 40. The exhaust port 34d surrounds the second ejection port 34c, and communicates with the exhaust device 39 with the exhaust pipe 40 interposed therebetween. The exhaust device 39 includes a tank 39a and an exhaust unit 39b. The exhaust unit 39b sucks gas through the exhaust port 34d and the exhaust pipe 40. The tank 39a houses the material 3 and fumes that are included in the gas sucked by the exhaust unit 39b. As a result, powders of the material 3 having not been used for manufacturing, fumes (metallic fumes) having been produced by the manufacturing, and refuse are discharged together with the gas from the main chamber 21. The exhaust unit 39b is a pump, for example.

The moving mechanism 38 moves the nozzle 34 in three axial directions orthogonal to one another. The moving mechanism 38 may rotate the nozzle 34 around two axial directions orthogonal to each other. The moving mechanism 38 moves the nozzle 34 relative to the stage 12. The moving device 13 also moves the nozzle 34 relative to the stage 12.

The first optical device 15 includes a first emission device 41, a first optical system 42, a measurement unit 43, and a plurality of first cables 46. The first optical system 42 is an example of the first irradiation unit. The first emission device 41 includes a first light source 41a and a first wavelength changing unit 41b.

The first light source 41a has an oscillation element and emits the first light L1 as a result of the oscillation of the oscillation element. In the first arrangement, the first light source 41a is a quantum cascade laser (QCL). The first light source 41a may be an interband cascade laser (ICL) or any of other light sources.

The first light source 41a can change power of the first light L1 emitted from the first light source 41a. The first light source 41a can further change (select) the wavelength of the first light L1 emitted from the first light source 41a. The wavelength of the emitted first light L1 is changed in accordance with a current supplied to the first light source 41a and a temperature of the oscillation element, for example. The first light source 41a may be capable of changing the wavelength of the emitted first light L1 in accordance with other parameters.

The first light source 41a is coupled to the first optical system 42 with the first cable 46, which is a hollow fiber. The first emission device 41 causes the first light L1 emitted from the first light source 41a to pass through the first cable 46 and to enter the first optical system 42. The first light L1 passes through the first optical system 42 and enters the nozzle 34. The first optical system 42 irradiates the object 2 and the material 3 ejected toward the object 2 with the first light L1 that is emitted from the first light source 41a and passed through the nozzle 34.

The first optical system 42 includes a first lens 51, a second lens 52, a third lens 53, a fourth lens 54, and a first galvano scanner 55. The first lens 51, the second lens 52, the third lens 53, and the fourth lens 54 are fixed. The first optical system 42 may include an adjustment device that can move the first lens 51, the second lens 52, the third lens 53, and the fourth lens 54 in two axial directions intersecting (orthogonal to) an optical path, for example.

The first lens 51 converts the first light L1, which enters the first optical system 42 after passing through the first cable 46, into parallel light. The first light L1 after being converted enters the first galvano scanner 55.

The second lens 52 converges the first light L1 emitted from the first galvano scanner 55. The first light L1 after being converged by the second lens 52 passes through the first cable 46 and reaches the nozzle 34.

The third lens 53 and the fourth lens 54 each converge the first light L1 emitted from the first galvano scanner 55. The object 2 is irradiated with the first light L1 after being converged by the third lens 53 and the fourth lens 54.

The first galvano scanner 55 splits parallel light after the conversion by the first lens 51 into light beams each of which enters the second lens 52, the third lens 53, the fourth lens 54, and the measurement unit 43. The first galvano scanner 55 includes a first galvano mirror 57, a second galvano mirror 58, and a third galvano mirror 59. Each of the galvano mirrors 57, 58, and 59 splits light into light beams and can change its tilting angle (emission angle).

The first galvano mirror 57 transmits part of the first light L1 after passing through the first lens 51, and emits the first light L1 after passing through the first galvano mirror 57 to the second galvano mirror 58. The first galvano mirror 57 reflects the other part of the first light L1, and emits the reflected first light L1 to the fourth lens 54. The first galvano mirror 57 changes an irradiation position of the first light L1 after passing through the fourth lens 54 in accordance with the tilting angle of the first galvano mirror 57.

The second galvano mirror 58 transmits part of the first light L1 after passing through the first galvano mirror 57, and emits the first light L1 after passing through the second galvano mirror 58 to the third galvano mirror 59. The second galvano mirror 58 reflects the other part of the first light L1, and emits the reflected first light L1 to the third lens 53. The second galvano mirror 58 changes an irradiation position of the first light L1 after passing through the third lens 53 in accordance with the tilting angle of the second galvano mirror 58.

The third galvano mirror 59 reflects part of the first light L1 after passing through the second galvano mirror 58, and emits the reflected first light L1 to the second lens 52. The third galvano mirror 59 transmits the other part of the first light L1, and emits the first light L1 after passing through the third galvano mirror 59 to the measurement unit 43.

The first optical system 42 includes a melting device 42a including the first galvano mirror 57, the second galvano mirror 58, and the third lens 53. The melting device 42a irradiates the material 3 supplied to the object 2 from the nozzle 34 with the first light L1 to heat the material 3 and to form the layer 2b, and performs annealing processing.

The first optical system 42 includes a removal device 42b including the first galvano mirror 57 and the fourth lens 54. The removal device 42b removes an unnecessary portion formed on the base 2a or the layer 2b by irradiating the unnecessary portion with the first light L1.

The removal device 42b removes portions different from a certain shape of the manufactured product 4, such as an unnecessary portion produced by the material 3 scattered in the supply of the material 3 from the nozzle 34, and an unnecessary portion produced in the formation of the layer 2b. The removal device 42b emits the first light L1 having power capable of removing the unnecessary portions.

The measurement unit 43 includes a specimen 61, a first photo detector 62, a beam splitter 63, and a second photo detector 64. The specimen 61 is the same powder as the material 3. The specimen 61 is housed in a transparent container having less absorption of irradiation light, for example. When the first photo detector 62 receives light transmitted through the specimen 61, the control device 18 obtains a transmittance (absorptivity) of the specimen 61 at the wavelength of light. When light has a sufficient wavelength range, the control device 18 can obtain a spectral transmittance of the specimen 61.

The following specifically describes exemplary calculation of the transmittance of the specimen 61. The calculation method of the transmittance of the specimen 61 is not limited to the following method. The first light L1 emitted from the third galvano mirror 59 passes through the beam splitter 63. The specimen 61 is irradiated with the first light L1 after passing through the beam splitter 63. The first light L1 after being transmitted by the specimen 61 enters the first photo detector 62.

FIG. 3 is a graph illustrating exemplary spectral distributions of the first light L1 detected by the first photo detector 62 and the second photo detector 64 in the first arrangement. In FIG. 3, the abscissa axis represents a wavelength while the vertical axis represents a relative radiation intensity. The first photo detector 62 outputs, to the control device 18, detection information S1 that is the spectral distribution of the first light L1 after being transmitted by the specimen 61. FIG. 3 illustrates the detection information S1 with the chain double-dashed line.

The beam splitter 63 illustrated in FIG. 1 reflects part of the first light L1 emitted from the third galvano mirror 59 and causes the reflected first light L1 to enter the second photo detector 64. The second photo detector 64 outputs, to the control device 18, reference information S2 that is the spectral distribution of the first light L1 not transmitted by the specimen 61. FIG. 3 illustrates the reference information S2 with the solid line.

When receiving the signals output from the first photo detector 62 and the second photo detector 64, the control device 18 calculates the absorptivity of the specimen 61 (material 3) at a wavelength. The control device 18 compensates a difference between the detection information S1 and the reference information S2. The difference is due to a difference in sensitivity between the first photo detector 62 and the second photo detector 64 or imbalance in dispersion of the first light L1 in the beam splitter 63. The control device 18 calculates compensation information S3 close to the detection information S1 by multiplying the reference information S2 by a coefficient, for example. FIG. 3 illustrates the compensation information S3 with the dashed line.

The control device 18 calculates a transmittance (detection information S1/compensation information S3) of the specimen 61 (material 3) at the wavelength by dividing the detection information S1 by the compensation information S3. The control device 18 calculates an absorptivity of the specimen 61 (material 3) at the wavelength from the transmittance. The measurement unit 43 irradiates the specimen 61 with the first light L1 emitted from the first emission device 41, and calculates the absorptivity of the material 3 at the wavelength of the first light L1.

As illustrated in FIG. 1, the first wavelength changing unit 41b is connected to the first light source 41a. The first wavelength changing unit 41b changes the current supplied to the first light source 41a so as to cause the first light source 41a to change the wavelength of the first light L1. The first wavelength changing unit 41b may cause the first light source 41a to change the wavelength of the first light L1 by another way such as changing the temperature of the oscillation element of the first light source 41a. The first emission device 41 including the first wavelength changing unit 41b can change the wavelength of the first light L1 entering the first optical system 42.

The measurement device 16 measures the shape of the solidified layer 2b and the shape of the manufactured product 4. The measurement device 16 transmits information about the measured shape to the control device 18. The measurement device 16 includes a camera 65 and an image processing device 66, for example. The image processing device 66 performs image processing on the basis of the information about the shape measured by the camera 65. The measurement device 16 measures the shapes of the layer 2b and the manufactured product 4 using an interference method or an optical cutting method, for example.

The second optical device 17 includes a second emission device 71, a second optical system 72, and a second cable 75. The second optical system 72 is an example of the second irradiation unit. The second emission device 71 includes a second light source 71a and a second wavelength changing unit 71b.

The second light source 71a has an oscillation element and emits second light L2 as a result of the oscillation of the oscillation element. In the first arrangement, the second light L2 is laser light and the second light source 71a is a quantum cascade laser (QCL). The second light source 71a may be an interband cascade laser (ICL) or any of other light sources.

The second light source 71a can change the power of the second light L2 emitted from the second light source 71a. In the same manner as the first light source 41a, the second light source 71a can further change (select) the wavelength of the second light L2 emitted from the second light source 71a.

The second light source 71a is coupled to the second optical system 72 with the second cable 75, which is a hollow fiber. The second emission device 71 causes the second light L2 emitted from the second light source 71a to pass through the second cable 75 and to enter the second optical system 72. The second optical system 72 irradiates the manufactured product 4 formed by the additive manufacturing with the material 3 with the second light L2 emitted from the second light source 71a.

The second optical system 72 includes a conversion lens 81, a converging lens 82, and a second galvano scanner 83, for example. The conversion lens 81 and the converging lens 82 are fixed. The second optical system 72 may include an adjustment device that can move the conversion lens 81 and the converging lens 82 in two axial directions intersecting (orthogonal to) an optical path, for example.

The conversion lens 81 converts the second light L2, which enters the second optical system 72 after passing through the second cable 75, into parallel light. The second light L2 after being converted enters the second galvano scanner 83.

The converging lens 82 converges the second light L2 emitted from the second galvano scanner 83. The manufactured product 4 is irradiated with the second light L2 after being converged by the converging lens 82.

The second galvano scanner 83 causes parallel light after conversion by the conversion lens 81 to enter the converging lens 82. The second galvano scanner 83 includes a galvano mirror 85. The galvano mirror 85 can change its tilting angle (emission angle).

The galvano mirror 85 reflects the second light L2 after passing through the conversion lens 81, and emits the reflected second light L2 to the converging lens 82. The galvano mirror 85 changes an irradiation position of the second light L2 after passing through the converging lens 82 in accordance with the tilting angle of the galvano mirror 85.

The second wavelength changing unit 71b is connected to the second light source 71a. The second wavelength changing unit 71b changes the current supplied to the second light source 71a so as to cause the second light source 71a to change the wavelength of the second light L2. The second wavelength changing unit 71b may cause the second light source 71a to change the wavelength of the second light L2 by another way such as changing the temperature of the oscillation element of the second light source 71a. The second emission device 71 including the second wavelength changing unit 71b can change the wavelength of the second light L2 entering the second optical system 72.

The control device 18 is electrically coupled to the moving device 13, the transfer device 24, the first material supply device 31, the second material supply device 32, the gas supply device 33, the exhaust device 39, the measurement unit 43, the first galvano scanner 55, the image processing device 66, and the second galvano scanner 83, respectively, with the signal line 19. The control device 18 is electrically connected to the first light source 41a and the first wavelength changing unit 41b that are included in the first emission device 41, and the second light source 71a and the second wavelength changing unit 71b that are included in the second emission device 71.

The control device 18 includes a control unit 18a such as a central processing unit (CPU), a storage unit 18b such as a read only memory (ROM), a random access memory (RAM), or a hard disk drive (HDD), and other various devices, for example. The control unit 18a controls various components of the additive manufacturing apparatus 1 including the first emission device 41 as a result of the CPU executing a program built in the ROM or the HDD.

The control unit 18a controls the moving device 13 so as to move the stage 12 in the three axial directions. The control unit 18a controls the transfer device 24 so as to transfer the manufactured product 4 to the sub chamber 22.

The control unit 18a controls the first material supply device 31 whether the first material supply device 31 supplies the first material 3A and a supply amount of the first material 3A when the first material supply device 31 supplies the first material 3A. The control unit 18a controls the second material supply device 32 whether the second material supply device 32 supplies the second material 3B and a supply amount of the second material 3B when the second material supply device 32 supplies the second material 3B.

The control unit 18a controls the gas supply device 33 whether the gas supply device 33 supplies the shield gas and a supply amount of the shield gas when the gas supply device 33 supplies the shield gas. The control unit 18a controls the moving mechanism 38 so as to control the position of the nozzle 34.

The control unit 18a controls the first galvano scanner 55 so as to adjust the respective tilting angles of the first galvano mirror 57, the second galvano mirror 58, and the third galvano mirror 59. The control unit 18a controls the second galvano scanner 83 so as to adjust the tilting angle of the galvano mirror 85.

The control unit 18a controls the first light source 41a of the first emission device 41 so as to adjust the power of the first light L1 emitted from the first light source 41a. The control unit 18a controls the first wavelength changing unit 41b so as to adjust the current supplied to the first light source 41a, thereby adjusting the wavelength of the first light L1 emitted from the first light source 41a.

The control unit 18a controls the second light source 71a of the second emission device 71 so as to adjust the power of the second light L2 emitted from the second light source 71a. The control unit 18a controls the second wavelength changing unit 71b so as to adjust the current supplied to the second light source 71a, thereby adjusting the wavelength of the second light L2 emitted from the second light source 71a.

The storage unit 18b stores therein data indicating the shape (reference shape) of the manufactured product 4 to be formed, for example. The storage unit 18b stores therein data indicating the heights of the nozzle 34 and the stage 12 for each of the three-dimensional processing positions (points).

The control unit 18a includes a function that selectively supplies a plurality of different materials 3 from the nozzle 34 and adjusts (changes) ratios among the multiple materials 3. For example, the control unit 18a controls the first material supply device 31 and the second material supply device 32 such that the layer 2b is formed by the materials 3 with the ratios based on data that is stored in the storage unit 18b and indicates the ratios among the respective materials 3. This function makes it possible to manufacture a gradient material (Functionally graded material), which is the manufactured product 4 in which the ratios among the multiple materials 3 change (gradually decreases or gradually increases) in accordance with the position (location) therein.

For example, when the layer 2b is formed, the control unit 18a controls the first material supply device 31 and the second material supply device 32 such that the ratios among the materials 3 becomes those set (stored) corresponding to the respective positions in the three-dimensional coordinate of the manufactured product 4. This control makes it possible to shape the manufactured product 4 as a gradient material in which the ratios among the materials 3 change in any of three-dimensional directions. A change amount (change rate) of the ratios among the materials 3 per unit length can also be set to any change amount.

The control unit 18a includes a function that determines the shape of the layer 2b or the manufactured product 4. For example, the control unit 18a determines whether a portion different from a certain shape is formed by comparing the shape of the layer 2b or the manufactured product 4, the shape being acquired by the measurement device 16, with the reference shape stored in the storage unit 18b.

The control unit 18a includes a function that trims and polishes the layer 2b or the manufactured product 4 into the certain shape by removing the unnecessary portion, which is determined to be the portion different from the certain shape in the determination of the shape of the layer 2b or the manufactured product 4. For example, the control unit 18a controls the first light source 41a such that the first light L1 emitted from the fourth lens 54 after being reflected by the first galvano mirror 57 has power capable of evaporating the material 3 of the portion different from the certain shape of the layer 2b or the manufactured product 4. The control unit 18a, then, controls the first galvano mirror 57 such that the portion is irradiated with the first light L1 and the portion is evaporated.

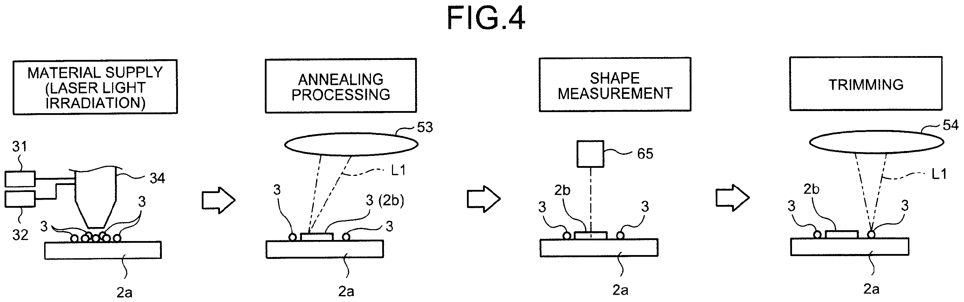

The following describes an exemplary manufacturing method of the manufactured product 4 by the additive manufacturing apparatus 1 with reference to FIG. 4. FIG. 4 is a schematic diagram schematically illustrating an exemplary procedure of the manufacturing processing (manufacturing method) by the additive manufacturing apparatus 1 in the first arrangement.

As illustrated in FIG. 4, first, the additive manufacturing apparatus 1 supplies the material 3 and irradiates the material 3 with the first light L1. The control unit 18a controls the first material supply device 31, the second material supply device 32, and the nozzle 34 such that the material 3 is supplied into a certain area from the nozzle 34. The control unit 18a controls the first light source 41a and the first optical system 42 such that the supplied material 3 is melt or sintered by the first light L1.

As illustrated in FIG. 2, the first optical system 42 irradiates the material 3 ejected from the nozzle 34 with the first light L1 through the nozzle 34. The material 3 ejected from the nozzle 34 is supplied into an area where the layer 2b is formed on the base 2a while the material 3 is melted or sintered by the first light L1. The material 3 that is not melt or sintered may reach the object 2.

The material 3 supplied to the object 2 gathers by being melted or sintered by irradiation with the first light L1. The gathered material 3 forms a molten region 91. The molten region 91 may include not only the supplied material 3 but also some of the base 2a and the layer 2b that are irradiated with the first light L1. The molten region 91 may include not only completely melted material 3 but also the material 3 partially melted and bonded.

As a result of the solidification of the molten region 91, the gathering of the material 3 is formed on the base 2a or the layer 2b in a layer shape or a thin film shape. The material 3 may be layered in a grain shape by being cooled by heat transmission to the gathering of the material 3, thereby forming the gathering in a grain shape.

As illustrated in FIG. 4, the additive manufacturing apparatus 1 performs the annealing processing. The control unit 18a controls the first emission device 41 and the melting device 42a such that the gathering of the material 3 on the base 2a is irradiated with the first light L1. The gathering of the material 3 is re-melted or re-sintered by the first light L1 to be solidified, thereby forming the layer 2b. As described above, the first optical system 42 irradiates the material 3 with the first light L1 emitted from the first emission device 41 to melt or sinter the material 3, thereby forming the layer 2b of the solidified material 3.

The additive manufacturing apparatus 1, then, measures the shape. The control unit 18a controls the measurement device 16 so as to measure the material 3 after being subjected to the annealing processing on the base 2a. The control unit 18a compares the shape of the layer 2b or the manufactured product 4, the shape being acquired by the measurement device 16, with the reference shape stored in the storage unit 18b.

The additive manufacturing apparatus 1, then, performs the trimming. For example, when it is determined that the material 3 on the base 2a sticks at a position different from a certain shape as a result of the comparison between the measured shape and the reference shape, the control unit 18a controls the first emission device 41 and the removal device 42b so as to evaporate the unnecessary material 3. When it is determined that the layer 2b has a certain shape as a result of the comparison between the measured shape and the reference shape, the control unit 18a omits the trimming.

When the formation of the layer 2b is completed, the additive manufacturing apparatus 1 forms a new layer 2b on the formed layer 2b. The additive manufacturing apparatus 1 layers the layer 2b repeatedly, thereby forming the manufactured product 4 by additive manufacturing.

When the manufactured product 4 is manufactured, the additive manufacturing apparatus 1 polishes the manufactured product 4. The control unit 18a controls the moving device 13 so as to move the stage 12 on which the manufactured product 4 has been manufactured at the manufacturing position P1 to the polishing position P2. At the manufacturing position P1, the nozzle 34 and the first optical system 42 are positioned above the stage 12. At the polishing position P2, the second optical system 72 is positioned above the stage 12.

The control unit 18a controls the first emission device 41 and the second optical system 72 so as to evaporate an unnecessary portion intentionally formed on the manufactured product 4 on the basis of the latest comparison result between the measured shape and the reference shape. The second optical system 72 irradiates the manufactured product 4 with the second light L2 so as to remove a part of the manufactured product 4. For example, the second optical system 72 removes a support temporarily formed on the manufactured product 4. The second optical system 72 may irradiate the manufactured product 4 with the second light L2 so as to reduce a surface roughness of the manufactured product 4. When it is determined that the manufactured product 4 has a certain shape as a result of the comparison between the measured shape and the reference shape, the control unit 18a omits the polishing.

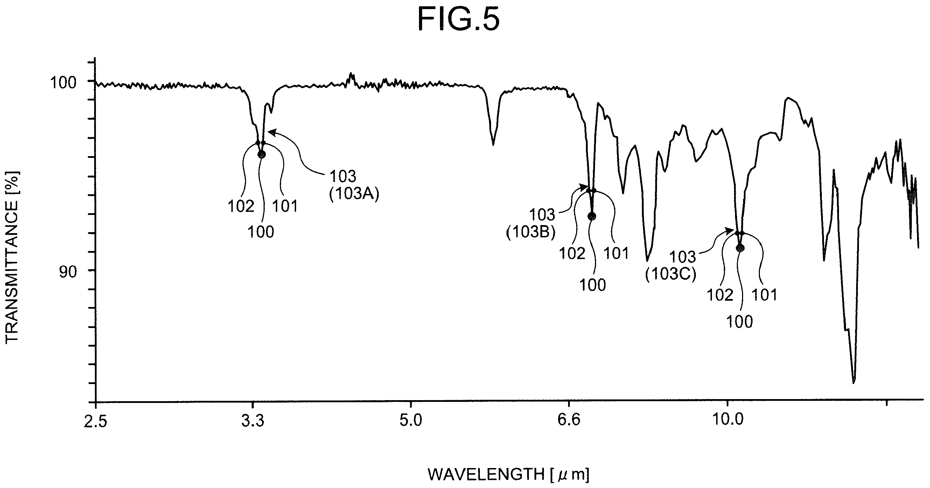

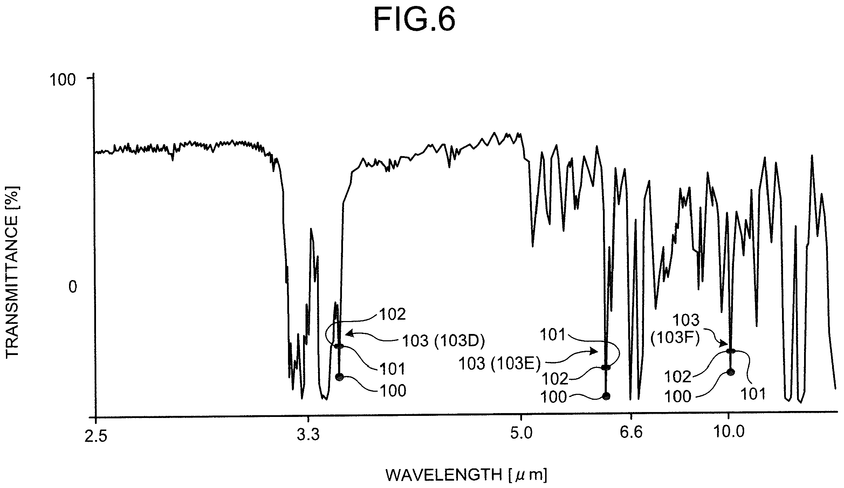

The following describes the first light L1 and the second light L2 in detail. FIG. 5 is a graph illustrating an example of the spectral transmittance of the first material 3A in the first arrangement. FIG. 6 is a graph illustrating an example of the spectral transmittance of the second material 3B in the first arrangement. In FIGS. 5 and 6, the abscissa axis represents a wavelength while the vertical axis represents a transmittance.

The storage unit 18b of the control device 18 stores therein the spectral transmittance of the first material 3A illustrated in FIG. 5 and the spectral transmittance of the second material 3B illustrated in FIG. 6. When the spectral transmittances of the first material 3A and the second material 3B are unknown, the additive manufacturing apparatus 1 preliminarily measures the spectral transmittances of the first material 3A and the second material 3B.

For example, the first wavelength changing unit 41b illustrated in FIG. 1 continuously changes the wavelength of the first light L1 emitted by the first light source 41a from a settable shortest wavelength to a settable longest wavelength. The first photo detector 62 receives the first light L1 after being transmitted by the specimen 61 while the second photo detector 64 receives the first light L1. As a result, the control unit 18a obtains the spectral transmittance of the specimen 61 (the first material 3A and the second material 3B). The control unit 18a causes the storage unit 18b to store therein the spectral transmittances of the first material 3A and the second material 3B.

As illustrated in FIGS. 5 and 6, each of the spectral transmittances of the first material 3A and the second material 3B has a plurality of peaks 100 in an infrared region. The transmittance at the peak 100 is lower than the transmittance at a point 101 at which the wavelength is slightly longer than the wavelength at the peak 100 and the transmittance at a point 102 at which the wavelength is slightly shorter than the wavelength at the peak 100. Each of the spectral transmittances of the first material 3A and the second material 3B has a plurality curves (peak curves) 103 each of which has a substantially bell shape and includes a peak 100.

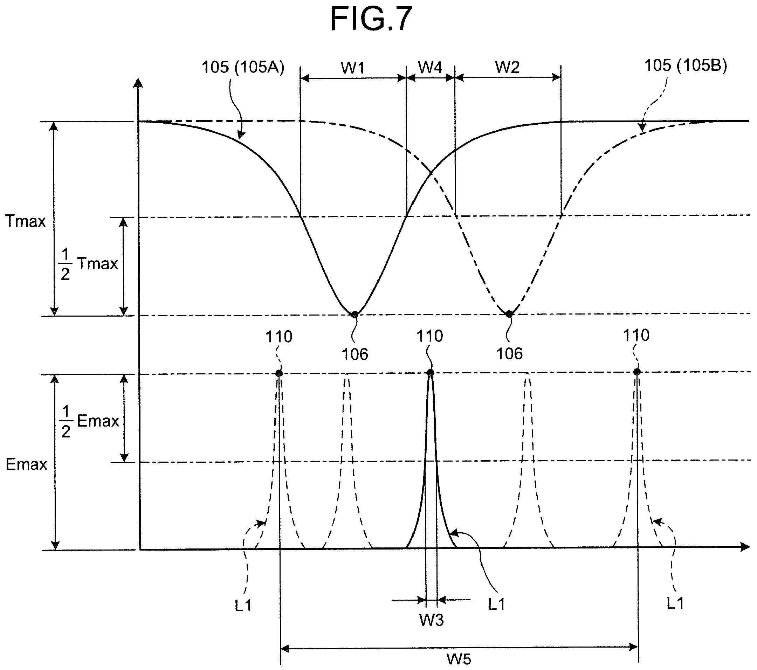

FIG. 7 is a graph illustrating a part of the spectral transmittance of the material 3 in the first arrangement, and exemplary spectral distributions of the first light L1 and the second light L2. In FIG. 7, the abscissa axis represents a wavelength while the vertical axis represents a transmittance and a relative radiation intensity. The control unit 18a extracts the multiple peak curves 103 from the spectral transmittance of the first material 3A and the second material 3B.

The control unit 18a performs, on each of the peak curves 103, fitting (Gaussian fitting) to obtain an approximated curve, which is a Gaussian function, to calculate an adjusted peak curve 105. The adjusted peak curve 105 is an example of the function that includes a peak obtained from an absorptivity of the material at a wavelength, and an example of the first function that includes a peak obtained from absorptivity of the material at a wavelength.

The adjusted peak curve 105 is a Gaussian function having a bell shape and includes a peak 106. The peak 106 of the adjusted peak curve 105 may differ from the peak 100 of the peak curve 103. The calculated adjusted peak curve 105 is stored in the storage unit 18b.

As illustrated in FIG. 7, the adjusted peak curve 105 (105A) is calculated from the peak curve 103 of the first material 3A while the adjusted peak curve 105 (105B) is calculated from the peak curve 103 of the second material 3B. The adjusted peak curve 105A is an example of the fourth function. The adjusted peak curve 105B is an example of the fifth function. The control unit 18a further calculates a half width W1 of the adjusted peak curve 105A and a half width W2 of the adjusted peak curve 105B.

The adjusted peak curve 105A and the adjusted peak curve 105B that are exemplarily illustrated in FIG. 7 have substantially the same shape. The adjusted peak curve 105A and the adjusted peak curve 105B may have different shapes from each other.

In the first arrangement, each of the half width W1 and the half width W2 is the full width at half maximum (FWHM). Each of the half width W1 and the half width W2 is the width between the wavelengths at each of which a difference between the transmittance of the material 3 (the specimen 61) and a minimum transmittance is 50% of Tmax (a peak value), which is a difference between a maximum transmittance and the minimum transmittance.

In the first arrangement, the wavelength range between the shortest wavelength and the longest wavelength in the half width W1 is described as a wavelength range W1 using the same symbol as the half width W1. The wavelength range W1 is the wavelength range corresponding to the half width W1 of the adjusted peak curve 105A. Likewise, the wavelength range between the shortest wavelength and the longest wavelength in the half width W2 is described as a wavelength range W2 using the same symbol as the half width W2. The wavelength range W2 is the wavelength range corresponding to the half width W2 of the adjusted peak curve 105B.

The wavelength at the peak 106 in the adjusted peak curve 105A differs from that at the peak 106 in the peak curve 105B. The wavelength range W1 and the wavelength range W2 differ from each other. The shortest wavelength in the wavelength range W1 is shorter than the shortest wavelength in the wavelength range W2. The longest wavelength in the wavelength range W1 is shorter than the longest wavelength of the wavelength range W2. The longest wavelength in the wavelength range W1 is shorter than the shortest wavelength in the wavelength range W2. The wavelength range W1 and the wavelength range W2 may partially overlap with each other.

A wavelength bandwidth W3 of the first light L1 emitted by the first light source 41a is narrower than the half width W1 and the half width W2. The wavelength bandwidth W3 of the first light L1 is the full width at half maximum (FWHM) of the light spectral distribution of the first light L1. The relative radiation intensity at each of the shortest wavelength and the longest wavelength in the wavelength width W3 is 50% of the peak value Emax.

The wavelength bandwidth W3 of the first light L1 is narrower than a gap W4 between the wavelength range W1 and the wavelength range W2. The gap W4 is the wavelength range between the longest wavelength in the wavelength range W1 and the shortest wavelength in the wavelength range W2.

The first light source 41a of the first emission device 41 can change (select) the wavelength of the first light L1 emitted from the first light source 41a in a variable range W5. The variable range W5 is an example of the wavelength range including the wavelength range corresponding to the half width of the function, the wavelength range including the wavelength range corresponding to the half width of the first function, the wavelength range including the wavelength range corresponding to the half width of the fourth function, the wavelength range including the wavelength range corresponding to the half width of the fifth function, and the wavelength range in which the wavelength of the first light is changeable.

The variable range W5 is the wavelength range between a peak 110 of the first light L1 at the shortest wavelength that the first light source 41a can emit and the peak 110 of the first light L1 at the longest wavelength that the first light source 41a can emit. In other words, the variable range W5 is a range in which the peak 110 of the first light L1 is changeable.

The width of the variable range W5 is wider than the half width W1 and the half width W2. The variable range W5 is wider than the gap W4. Each of the wavelength range W1, the wavelength range W2, and the gap W4 is (included) in the variable range W5.

The control unit 18a controls the first wavelength changing unit 41b so as to cause the first emission device 41 to change the wavelength of the first light L1. In the first arrangement, the first wavelength changing unit 41b controlled by the control unit 18a changes the wavelength of the first light L1 in the variable range W5. In other words, the first wavelength changing unit 41b changes the wavelength of the first light L1 in a wavelength range including the wavelength range W1, the wavelength range W2, and the gap W4. The variable range W5 includes the wavelength range from the shortest wavelength that the first light source 41a can emit to the shortest wavelength in the wavelength range W1 and the wavelength range from the longest wavelength in the wavelength range W2 to the longest wavelength that the first light source 41a can emit.

For example, when the first material 3A is melted or sintered, the first wavelength changing unit 41b changes the wavelength of the first light L1 to a wavelength in or near the wavelength range W1. When the wavelength of the first light L1 is set to a wavelength outside the wavelength range W2, and the first material 3A is melted or sintered, the second material 3B may be supplied simultaneously.

When the wavelength of the first light L1 is changed to a wavelength near the peak 106 of the adjusted peak curve 105A, the first material 3A is efficiently melted or sintered, and a depth (penetration depth) D, which is illustrated in FIG. 2, of the molten region 91 of the first material 3A is shallow. The penetration depth D is obtained by expression (1), for example:

$$D = 1/\alpha \quad \text{expression (1)}$$

where $\alpha$ is the absorbance of the material 3.

The absorbance $\alpha$ of the material 3 can be obtained by expression (2), expression (3), and expression (4):

$$T = I/I_0 = e^{-\alpha x} \quad \text{expression (2)}$$

$$\ln T = -\alpha x \quad \text{expression (3)}$$

$$\alpha = -\ln T/x \quad \text{expression (4)}$$

where T is the transmittance of the material 3 having a length of x, x is the length of the material 3 through which the first light L1 passes, I is the intensity of the first light L1 after passing through the material 3, and $I_0$ is the intensity of the first light L1 before entering the material 3.

When the wavelength of the first light L1 is changed to a wavelength slightly outside the wavelength range W1, the efficiency in melting or sintering the first material 3A deteriorates. In addition, the first light L1 easily passes through the first material 3A. As a result, the penetration depth D of the molten region 91 becomes deep.

The control unit 18a controls the first wavelength changing unit 41b such that a melting or sintering speed of the first material 3A and the penetration depth D of the molten region 91 become respective certain values. The first wavelength changing unit 41b changes the wavelength of the first light L1 in a wavelength range in which an amount of change in the adjusted peak curve 105 is gentile, for example.

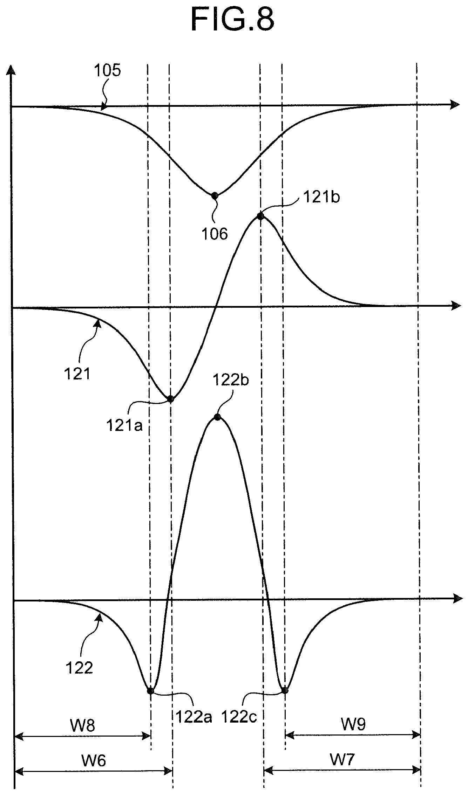

FIG. 8 is a graph illustrating examples of the adjusted peak curve 105 in the first arrangement, and a first derivative 121 and a second derivative 122 of the adjusted peak curve 105. In FIG. 8, the abscissa axis represents a wavelength while the vertical axis represents a transmittance and an amount of change in the transmittance.

The control unit 18a calculates the first derivative 121 illustrated in FIG. 8 by first differentiating the adjusted peak curve 105 (105A, 105B). The first derivative 121 is an example of the second function. The control unit 18a calculates the second derivative 122 by second-order differentiating the adjusted peak curve 105 (105A, 105B). The second derivative 122 is an example of the third function.

The first derivative 121 has two inflection points, that is, inflection points 121a and 121b. The wavelength of the inflection point 121a is the shortest among the wavelengths of the two inflection points of the first derivative 121. The wavelength of the inflection point 121b is the longest among the wavelengths of the two inflection points of the first derivative 121.

The second derivative 122 has three inflection points, that is, inflection points 122a, 122b, and 122c. The wavelength of the inflection point 122a is the shortest among the wavelengths of the three inflection points of the second derivative 122. The wavelength of the inflection point 122c is the longest among the wavelengths of the three inflection points of the second derivative 122. The wavelength of the inflection point 122b is shorter than the wavelength of the inflection point 122c and longer than the wavelength of the inflection point 122a.

The first wavelength changing unit 41b changes the wavelength of the first light L1 in a wavelength range W6 between the shortest wavelength in the adjusted peak curve 105 and the wavelength of the inflection point 121a, and in a wavelength range W7 between the wavelength of the inflection point 121b and the longest wavelength in the adjusted peak curve 105. In the wavelength ranges W6 and W7, an amount of change in the adjusted peak curve 105 is relatively gentle. As a result, a change in amount of the first light L1 absorbed by the first material 3A is gentle.

The first wavelength changing unit 41b may change the wavelength of the first light L1 in a wavelength range W8 between the shortest wavelength in the adjusted peak curve 105 and the wavelength of the inflection point 122a, and in a wavelength range W9 between the wavelength of the inflection point 122c and the longest wavelength in the adjusted peak curve 105. In the wavelength ranges W8 and W9, an amount of change in the adjusted peak curve 105 is more gentle. As a result, a change in amount of the first light L1 absorbed by the first material 3A is more gentle.

The amount of the first light L1 absorbed by the first material 3A is determined by the output of the first light source 41a, the relative radiation intensity of the first light L1 at a set wavelength, and the transmittance (absorptivity) of the first material 3A at the set wavelength. The temperature of the first material 3A changes in accordance with the amount of the first light L1 absorbed by the first material 3A.

When the change in amount of the first light L1 absorbed by the first material 3A is gentle, it is easy to control the temperature of the first material 3A irradiated with the first light L1. As a result, melting or sintering the first material 3A can be easily controlled.

For example, when the second material 3B is melted or sintered, the first wavelength changing unit 41b changes the wavelength of the first light L1 to a wavelength in or near the wavelength range W2 illustrated in FIG. 7. The control unit 18a controls the first wavelength changing unit 41b such that a melting or sintering speed of the second material 3B and the penetration depth D of the molten region 91 become respective certain values. When the wavelength of the first light L1 is set to a wavelength outside the wavelength range W1, and the second material 3B is melted or sintered, the first material 3A may be supplied simultaneously.

When the wavelength of the first light L1 is changed to a wavelength near the peak 106 of the adjusted peak curve 105B, the second material 3B is efficiently melted or sintered, and the penetration depth D of the molten region 91 of the second material 3B is shallow. When the wavelength of the first light L1 is changed to a wavelength slightly outside the wavelength range W2, the efficiency in melting or sintering the second material 3B deteriorates, and the penetration depth D of the molten region 91 of the second material 3B becomes deep.

For example, when the first material 3A and the second material 3B are melted or sintered, the first wavelength changing unit 41b changes the wavelength of the first light L1 in the wavelength range W1 and in wavelength range W2 alternately. In this case, the first material 3A and the second material 3B are simultaneously supplied by the supply unit 31b and the supply unit 32b, respectively. The first material 3A and the second material 3B may be supplied alternately.

The wavelength of the first light L1 is changed faster as compared with supply rates of the first material 3A and the second material 3B between in the wavelength range W1 and in the wavelength range W2 alternately. The first material 3A and the second material 3B ejected from the nozzle 34 are thus irradiated with the first light L1 having a wavelength set in the wavelength range W1 and the first light L1 having another wavelength set in the wavelength range W2 until the first material 3A and the second material 3B reach the object 2, thereby being melted or sintered.

For example, when the first material 3A and the second material 3B are not melted or sintered, the first wavelength changing unit 41b changes the wavelength of the first light L1 to a wavelength in the wavelength range of the gap W4. As a result, the first material 3A and the second material 3B are prevented from being melted or sintered even when the first material 3A and the second material 3B are irradiated with the first light L1, thereby remaining in a powder form.

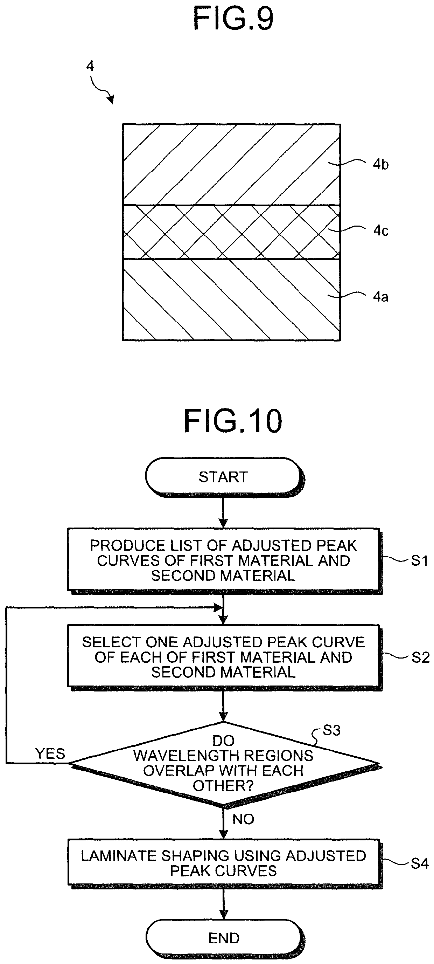

FIG. 9 is a cross-sectional view schematically illustrating a part of the manufactured product 4 in the first arrangement. As illustrated in FIG. 9, the manufactured product 4 made by the additive manufacturing apparatus 1 includes a first layer 4a, a second layer 4b, and a third layer 4c.

The first layer 4a is made of the layer 2b of the melted or sintered first material 3A. The first layer 4a may include the second material 3B that is not melted or sintered and is in a powder form. The second layer 4b is made of the layer 2b of the melted or sintered second material 3B. The second layer 4b may include the first material 3A that is not melted or sintered and is in a powder form.

The third layer 4c is made of the melted or sintered first material 3A and the melted or sintered second material 3B. The third layer 4c may include the first material 3A and the second material 3B that are not melted or sintered and are in a powder form.

A ratio between the melted or sintered first material 3A and the melted or sintered second material 3B in the third layer 4c is determined by the wavelength of the first light L1. For example, as a time period in which the wavelength of the first light L1 is in the wavelength range W1 becomes longer than a time period in which the wavelength of the first light L1 is set in the wavelength range W2, the ratio of the first material 3A increases more. A gradient material in which the ratio between the first material 3A and the second material 3B changes is manufactured by gradually changing a time period in which the wavelength of the first light L1 is set in the wavelength range W1 and a time period in which the wavelength of the first light L1 is set in the wavelength range W2. The manufacturing of the gradient material is not limited to this example. The gradient material is also manufactured by such adjusting that the wavelength of the first light L1 gradually changes.

As described above, the wavelength of the emitted first light L1 is changed in accordance with a current supplied to the first light source 41a and a temperature of the oscillation element. The wavelength of the first light L1 is, thus, changed in some cases due to a change in temperature of the oscillation element even when the current supplied to the first light source 41a from the first wavelength changing unit 41b is constant.

As illustrated in FIG. 1, during a time period in which the first light source 41a emits the first light L1, the first photo detector 62 and the second photo detector 64 of the measurement unit 43 output information (the detection information S1 and the reference information S2) about the transmittance of the first light L1 in the material 3. In other words, the measurement unit 43 measures the absorptivity of the material 3 for the first light L1.

Based on the measured transmittance (the absorptivity), the control unit 18a controls the first wavelength changing unit 41b such that the wavelength of the first light L1 becomes a desired wavelength. The first light L1 is changed by feedback control based on the transmittance measured by the measurement unit 43.

The control unit 18a controls the second wavelength changing unit 71b in the same manner as the first wavelength changing unit 41b. The wavelength bandwidth W3 of the second light L2 is narrower than the half width W1 and the half width W2. The second wavelength changing unit 71b changes the wavelength of the second light L2 emitted from the second light source 71a in the variable range W5. The control unit 18a controls the second wavelength changing unit 71b such that the first material 3A and the second material 3B that form a part of the manufactured product 4 can be removed, for example.

As described above, the control unit 18a controls the first wavelength changing unit 41b and the second wavelength changing unit 71b so as to change the wavelengths of the first light L1 and the second light L2 on the basis of the wavelength range W1 corresponding to the half width W1 in the adjusted peak curve 105A and the wavelength range W2 corresponding to the half width W2 in the adjusted peak curve 105B. The control unit 18a determines the adjusted peak curve 105A used for determining the change in wavelength of the first light L1 and the adjusted peak curve 105B used for determining the change in wavelength of the second light L2 in the following exemplary manner.

FIG. 10 is a flowchart illustrating an example of adjusted peak curve selection processing in the first arrangement. As illustrated in FIG. 10, the control unit 18a produces a list of the adjusted peak curves 105A of the first material 3A and a list of the adjusted peak curves 105B of the second material 3B (S1).

As illustrated in FIG. 5, the spectral transmittance, which is stored in the storage unit 18b, of the first material 3A includes the multiple peak curves 103 (103A, 103B, 103C, and so on), for example. The control unit 18a calculates the adjusted peak curves 105A of the respective peak curves 103 (103A, 103B, 103C, and so on), and the first derivatives 121 and the second derivatives 122 of the respective adjusted peak curves 105A. The control unit 18a stores, in the storage unit 18b, the adjusted peak curves 105A of the respective peak curves 103 (103A, 103B, 103C, and so on), the first derivatives 121, and the second derivatives 122 in association with one another.

As illustrated in FIG. 6, the spectral transmittance, which is stored in the storage unit 18b, of the second material 3B includes the multiple peak curves 103 (103D, 103E, 103F, and so on). The control unit 18a calculates the adjusted peak curves 105B of the respective peak curves 103 (103D, 103E, 103F, and so on), and the first derivatives 121 and the second derivatives 122 of the respective adjusted peak curves 105B. The control unit 18a stores, in the storage unit 18b, the adjusted peak curves 105B of the respective peak curves 103 (103D, 103E, 103F, and so on), the first derivatives 121, and the second derivatives 122 in association with one another.

The control unit 18a lists the adjusted peak curves 105 of the respective peak curves 103 (103A, 103B, 103C, 103D, 103E, 103F, and so on), and the first derivatives 121 and the second derivatives 122 of the respective adjusted peak curves 105. As a result, the list of the adjusted peak curves 105A of the first material 3A and the list of the adjusted peak curves 105B of the second material 3B are produced. The peak curves 103 outside the variable range W5 are omitted from the lists.

The control unit 18a selects one of the adjusted peak curves 105A of the first material 3A and the one of the adjusted peak curves 105B of the second material 3B from the respective lists (S2). For example, the control unit 18a selects the adjusted peak curve 105B having the wavelength range W2 close to the wavelength range W1 in the selected adjusted peak curve 105A.

The control unit 18a determines whether the wavelength range W1 in the selected adjusted peak curve 105A and the wavelength range W2 in the selected adjusted peak curve 105B overlap with each other (S3). If the wavelength range W1 and the wavelength range W2 overlap with each other (Yes at S3), the control unit 18a newly selects the adjusted peak curve 105A and the adjusted peak curve 105B (S2).

If the wavelength range W1 and the wavelength range W2 do not overlap with each other and are apart from each other (No at S3), then the control unit 18a starts the additive manufacturing using the selected adjusted peak curves 105A and 105B (S4). The selection of the adjusted peak curves 105A and 105B respectively having the wavelength ranges W1 and W2 that do not overlap with each other makes it possible to change the wavelength of the first light L1 to a wavelength in the wavelength range of the gap W4 to prevent the first material 3A and the second material 3B from being melted or sintered. The control unit 18a may select the adjusted peak curves 105A and 105B having the wavelength ranges W1 and W2 that overlap with each other.

In the additive manufacturing apparatus 1 in the first arrangement, the first optical system 42 irradiates the material 3 with the first light L1 emitted from the first emission device 41 to melt or sinter the material 3. The first emission device 41 changes the wavelength of the first light L1 entering the first optical system 42. The wavelength bandwidth W3 of the first light L1 is narrower than the half width W1 of the adjusted peak curve 105A having the peak 106 and the half width W2 of the adjusted peak curves 105B having the peak 106, the adjusted peak curves 105A and 105B being obtained from the absorptivities of the materials 3A and 3B at a wavelength, respectively. The wavelength of the first light L1 is changed in the variable range W5 including the wavelength range W1 in the adjusted peak curve 105A and the wavelength range W2 in the adjusted peak curve 105B. The first wavelength changing unit 41b changes the wavelength of the first light L1 in accordance with the absorptivity (spectral transmittance) of the material 3 at a wavelength. As a result, the melting or sintering of the material 3 irradiated with the first light L1 is controlled. For example, the first emission device 41 sets the wavelength of the first light L1 to a wavelength at which the absorptivity of the material 3 is high, thereby making it possible to efficiently melt or sinter the material 3. As a result, the additive manufacturing can be performed without mixing a solidification additive such as an ultraviolet curing resin into the material 3. The prevention of the mixing of the additive prevents the deterioration of physical performances (e.g., dimension accuracy, surface accuracy, roughness, and thermal conductivity) of the manufactured product 4. The first emission device 41 sets the wavelength of the first light L1 to a wavelength at which the absorptivity of the material 3 is high, thereby making it possible to reduce the penetration depth D of the melted or sintered material 3. As a result, the additive manufacturing can be performed highly accurately. The first emission device 41 can control the temperature of the material 3 irradiated with the first light L1 by varying the wavelength of the first light L1. The temperature control of the material 3 by the wavelength of the first light L1 is more accurate than the temperature control of the material 3 by the power of the first light L1. As a result, the additive manufacturing can be performed highly accurately. Consequently, a desired manufacturing efficiency can be achieved and the manufactured product 4 having a desired performance such as high accuracy can be formed by the additive manufacturing.

The first light source 41a can change the wavelength of the first light L1 emitted from the first light source 41a. The first wavelength changing unit 41b causes the first light source 41a to change the wavelength of the first light L1. The wavelength of the first light L1 is, thus, easily changeable.

The storage unit 18b is made to store therein the adjusted peak curve 105 including the peak 106, the adjusted peak curve 105 being obtained from the absorptivity of the material 3 at a wavelength. The first wavelength changing unit 41b changes the wavelength of the first light L1 in the variable range W5 including the wavelength range W1 in the adjusted peak curve 105A and the wavelength range W2 in the adjusted peak curve 105B. This change makes it possible for the wavelength of the first light L1 to be set to a frequency at which the absorptivity of the material 3 is high, thereby making it possible to perform the additive manufacturing without mixing the solidification additive such as an ultraviolet curing resin into the material 3.

The measurement unit 43 irradiates the specimen 61 with the first light L1 and measures the absorptivity of the material 3 at the wavelength of the first light L1. Even when the absorptivity of the material 3 at the wavelength is unknown, the absorptivity of the material 3 at the wavelength can be obtained in this way. The additive manufacturing apparatus 1 including the measurement unit 43, thus, can perform feedback control in response to a change in temperature, thereby making it possible to control more accurately the temperature of the material 3 irradiated with the first light L1. The measurement unit 43 may be disposed outside the additive manufacturing apparatus 1.

The wavelength of the first light L1 emitted from the first light source 41a is changed in accordance with multiple parameters such as a supplied current and a temperature of the element in some cases. In the first arrangement, the absorptivity of the material 3 for the first light L1 are measured, and the wavelength of the first light L1 is changed on the basis of the measured absorptivity. Even when an unwanted change occurs in one of the parameters, a change in the wavelength of the first light L1 is measured in real-time. The wavelength of the first light L1 can be kept in a desired wavelength. As a result, the temperature can be accurately controlled and the additive manufacturing can be performed highly accurately.

The first supply pipe 35 removes charge from the material 3 supplied by the supply unit 31b while the second supply pipe 36 removes charge from the material 3 supplied by the supply unit 32b. As a result, a variation of a material supply amount can be reduced and the additive manufacturing can be performed highly accurately.

The first light source 41a is a QCL. The wavelength of the first light L1 emitted from the QCL is changed by the current supplied to the QCL and the temperature of the element. As a result, the wavelength of the first light L1 can be easily changed.

The second optical system 72 irradiates the manufactured product 4 formed of the material 3 by the additive manufacturing with the second light L2 so as to remove a part of the manufactured product 4. The second emission device 71 can change the wavelength of the second light L2. The second emission device 71 changes the wavelength of the second light L2 in accordance with the absorptivity of the material 3 at a wavelength so as to remove only a part of the manufactured product 4 manufactured by the first material 3A or only a part of the manufactured product 4 manufactured by the second material 3B, for example. As a result, the additive manufacturing can be performed highly accurately.

The width of the variable range W5 in which the wavelength of the first light L1 is changeable is wider than the half width W1 of the adjusted peak curve 105A and the half width W2 of the adjusted peak curve 105B. As a result, the wavelength of the first light L1 is changeable to a wavelength in the wavelength range other than the wavelength ranges W1 and W2. As a result, the melting or sintering of the material 3 irradiated with the first light L1 is controlled more accurately.

The wavelength of the first light L1 is changed in at least one of the wavelength ranges W6 and W7. The wavelength range W6 is from the shortest wavelength in the adjusted peak curve 105 to the wavelength of the inflection point 121a whose wavelength is the shortest in the first derivative 121 obtained by differentiating the adjusted peak curve 105. The wavelength range W7 is from the wavelength of the inflection point 121b whose wavelength is the longest in the first derivative 121 to the longest wavelength in the adjusted peak curve 105. The wavelength of the first light L1 is changed in the wavelength range in which the change in absorptivity of the material 3 at the wavelength is relatively gentle. As a result, the temperature of the material 3 irradiated with the first light L1 can be controlled accurately.

The wavelength of the first light L1 is changed in at least one of the wavelength ranges W8 and W9. The wavelength range W8 is from the shortest wavelength in the adjusted peak curve 105 to the wavelength of the inflection point 122a whose wavelength is the shortest in the second derivative 122 obtained by second-order differentiating the adjusted peak curve 105. The wavelength range W9 is from the wavelength of the inflection point 122c whose wavelength is the longest in the second derivative 122 to the longest wavelength in the adjusted peak curve 105. The wavelength of the first light L1 is changed in the region in which the change in absorptivity of the material 3 at the wavelength is relatively gentle. As a result, the temperature of the material 3 irradiated with the first light L1 can be controlled accurately.

The wavelength of the first light L1 is in the variable range W5 including the wavelength range W1 in the adjusted peak curve 105A and the wavelength range W2 in the adjusted peak curve 105B. As a result, the manufactured product 4 including multiple materials, that is, the materials 3A and 3B, can be accurately formed by additive manufacturing.

The wavelength bandwidth W3 of the first light L1 is narrower than the gap W4 between the longest wavelength in the wavelength range W1 in the adjusted peak curve 105A and the shortest wavelength in the wavelength range W2 in the adjusted peak curve 105B. As a result, the manufactured product 4 that includes the first layer 4a of only the solidified first material 3A and the second layer 4b of only the solidified second material 3B can be formed by additive manufacturing. Furthermore, the manufactured product 4 including the third layer 4c in which both of the first material 3A and the second material 3B are solidified can be manufactured by changing the wavelength of the first light L1 in the wavelength range W1 in the adjusted peak curve 105A and in the wavelength range W2 in the adjusted peak curve 105B alternately.

For example, when the irradiation of the material 3 with the first light L1 is stopped in the case where the material 3 needs not to be melted and the irradiation of the material 3 with the first light L1 is started again in the case where the material 3 needs to be melted, a surge current may inversely affect the wavelength of the first light L1. In the first arrangement, the melting or sintering of the first material 3A and the second material 3B can be stopped without stopping the irradiation of the first material 3A and the second material 3B with the first light L1 by setting the wavelength of the first light L1 to a wavelength in the gap W4, which is between the longest wavelength in the wavelength range W1 in the adjusted peak curve 105A and the shortest wavelength in the wavelength range W2 in the adjusted peak curve 105B. As a result, the manufactured product 4 including multiple materials, that is, the materials 3A and 3B, can be accurately formed by additive manufacturing.

The wavelength of the first light L1 can be changed faster as compared with supply rates of the first material 3A and the second material 3B between in the wavelength range W1 in the adjusted peak curve 105A and in the wavelength range W2 in the adjusted peak curve 105B alternately. As a result, the manufactured product 4 including the third layer 4c in which both of the first material 3A and the second material 3B are solidified can be manufactured by changing the wavelength of the first light L1 to a wavelength in the wavelength range W1 in the adjusted peak curve 105A and another wavelength in the wavelength range W2 in the adjusted peak curve 105B alternately during the time period in which the first material 3A and the second material 3B are supplied.

The following describes a modification of the first arrangement. In the first arrangement, the manufactured product 4 includes the first layer 4a made of the first material 3A, the second layer 4b made of the second material 3B, and the third layer 4c made of the first material 3A and the second material 3B. In the modification of the first arrangement, the manufactured product 4 includes only the first layer 4a and the second layer 4b. The second layer 4b is formed by additive manufacturing as a supporting material that supports the first layer 4a. The second layer 4b is removed after the manufactured product 4 is formed by the additive manufacturing.

For example, the first optical system 42 irradiates the second layer 4b with the first light L1 after the manufactured product 4 is formed by additive manufacturing. The first wavelength changing unit 41b changes the wavelength of the first light L1 to a wavelength outside the wavelength range W1 and within the wavelength range W2. The second layer 4b made of the solidified second material 3B is, thus, irradiated with the first light L1 having the wavelength outside the wavelength range W1 and within the wavelength range W2.

The first light L1 melts or evaporates the second material 3B. The second layer 4b is, thus, removed from the manufactured product 4. Even when the first layer 4a is irradiated with the first light L1, the first layer 4a made of the first material 3A remains without being melted or evaporated.

In the additive manufacturing apparatus 1 according to the modification of the first arrangement described above, the solidified second material 3B is irradiated with the first light L1 having a wavelength outside the wavelength range W1 in the adjusted peak curve 105A and within the wavelength range W2 in the adjusted peak curve 105B. As a result, the second material 3B is melted or evaporated. This makes it possible to easily remove the second layer 4b that is made of the second material 3B and formed so as to support the first layer 4a made of the first material 3A, for example. The second layer 4b may be removed by the second light L2.

Second arrangement

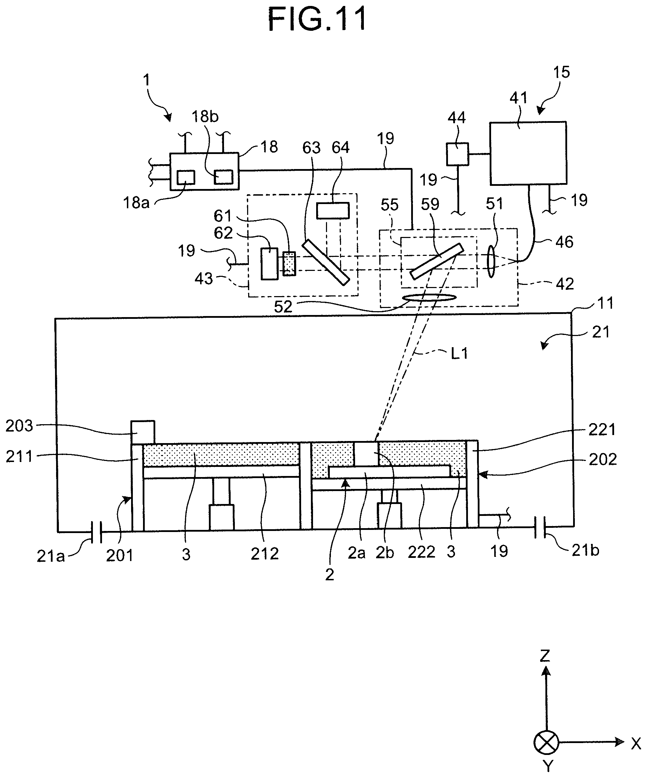

The following describes a second arrangement with reference to FIG. 11. In the following description on the second arrangement, constituent elements having the same functions as already described constituent elements may be labeled with the same numerals and descriptions thereof may be omitted. The constituent elements labeled with the same numerals are not limited to have all of the functions and characteristics in common with each other, and may have different functions and characteristics in accordance with the respective arrangements.

FIG. 11 is a schematic diagram schematically illustrating the additive manufacturing apparatus 1 according to the second arrangement. As illustrated in FIG. 11, the additive manufacturing apparatus 1 in the second arrangement is a powder bed three-dimensional printer.

As illustrated in FIG. 11, the additive manufacturing apparatus 1 of the second arrangement includes the processing tank 11, the first optical device 15, the control device 18, the multiple signal lines 19, a supply tank 201, a manufacturing tank 202, and a supply device 203. The supply tank 201, the manufacturing tank 202, and the supply device 203 are arranged in the main chamber 21.

The supply tank 201 has a circumferential wall 211 and a lifting wall 212. The circumferential wall 211 is formed in a tubular shape extending along the Z-axis direction. The lifting wall 212, which is disposed inside the circumferential wall 211, can be moved in a direction along the Z axis by a hydraulic lifter, for example.

The supply tank 201 houses the material 3. The lifting wall 212 supports the material 3. As the lifting wall 212 is lifted, the material 3 supported by the lifting wall 212 flows outside the circumferential wall 211 from the upper edge of the circumferential wall 211.

The manufacturing tank 202 is disposed adjacent to the supply tank 201. The manufacturing tank 202 has a circumferential wall 221 and a lifting wall 222. The circumferential wall 221 is formed in a tubular shape extending along the Z-axis direction. The lifting wall 222, which is disposed inside the circumferential wall 221, can be moved in a direction along the Z axis by a hydraulic lifter, for example. The lifting wall 222 supports the object 2.

The supply device 203 is a flexible paddle (squeezing blade), for example. The supply device 203 may be a roller, for example. The supply device 203 pushes the material flowed outside the circumferential wall 211 toward the manufacturing tank 202. As a result, the material 3 is supplied to the manufacturing tank 202.

The powdered material 3 supplied to the manufacturing tank 202 forms a layer. The layer of the material 3 is formed on the material 3 already supplied and the object 2. In the second arrangement, the first optical device 15 irradiates the layer of the material 3 formed in the manufacturing tank 202 with the first light L1. As illustrated in FIG. 11, the first optical system 42 in the second arrangement directly irradiates the layer of the material 3 with the first light L1 after being converged by the second lens 52. The first optical device 15 may irradiate the layer of the first material 3 with the first light L1 after passing through the first cable 46 and the nozzle 34 in the same manner as the first arrangement.

The first light L1 melts or sinters a certain portion of the layer of the material 3 to form the layer 2b. Once the layer 2b is formed, the lifting wall 212 moves upward and the lifting wall 222 moves downward. The supply device 203 supplies the material 3 to the manufacturing tank 202 to form the layer of the powdered material 3 again. The formation of the layer of the material 3 and the formation of the layer 2b by the first light L1 are repeated as described above. As a result, the manufactured product 4 is formed by additive manufacturing.

In the additive manufacturing apparatus 1 in the second arrangement described above, the first emission device 41 changes the wavelength of the first light L1 entering the first optical system 42. The wavelength bandwidth W3 of the first light L1 is narrower than the half width W1 of the adjusted peak curve 105A having the peak 106 and the half width W2 of the adjusted peak curve 105B having the peak 106, the adjusted peak curves 105A and 105B being obtained from the absorptivities of the material 3A and 3B at a wavelength, respectively. The wavelength of the first light L1 is changed in the variable range W5 including the wavelength range W1 in the adjusted peak curve 105A and the wavelength range W2 in the adjusted peak curve 105B. Consequently, in the same manner as the first arrangement, a desired manufacturing efficiency can be achieved and the manufactured product 4 having a desired performance such as high accuracy can be formed by additive manufacturing.

Third arrangement

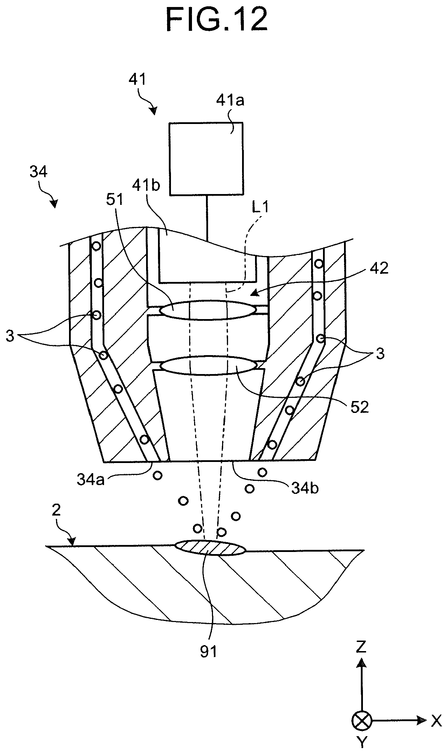

The following describes a third arrangement with reference to FIG. 12. FIG. 12 is a cross-sectional view illustrating the nozzle 34 according to the third arrangement and the object 2. As illustrated in FIG. 12, in the third arrangement, the first emission device 41 and the first optical system 42 are provided in the nozzle 34.

For example, the first light source 41a, the first wavelength changing unit 41b, the first lens 51, and the second lens 52 are provided in the nozzle 34. The first light source 41a emits, from the emission port 34b, the first light L1 after passing through the first lens 51 and the second lens 52 that are fixed in the nozzle 34.

In the additive manufacturing apparatus 1 in the third arrangement, the first emission device 41 and the first optical system 42 are provided in the nozzle 34, which supplies the material 3 to the object 2 and is moved by the moving mechanism 38. As a result, the position irradiated with the first light L1 can be changed without using a complicated device such as a galvano scanner.

Fourth arrangement

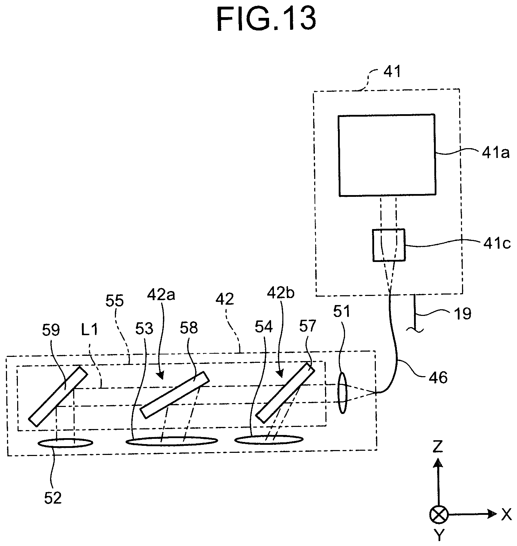

The following describes a fourth arrangement with reference to FIG. 13. FIG. 13 is a schematic diagram schematically illustrating the first emission device 41 and the first optical system 42 in the fourth arrangement. As illustrated in FIG. 13, the first emission device 41 in the fourth arrangement includes the first light source 41a and a wavelength change component 41c.

In the fourth arrangement, the first light source 41a is a light source that can emit the first light L1 having a wide wavelength range such as a lamp. The wavelength change component 41c changes the wavelength of the first light L1 emitted from the first light source 41a and causes the first light L1 to pass through the first cable 46 and enter the first optical system 42.

The wavelength change component 41c is a grating (diffraction grating), for example. The wavelength change component 41c changes, by being rotated, the wavelength of the first light L1 entering the first optical system 42.

The wavelength change component 41c is not limited to the grating. For example, the wavelength change component 41c may be another device such as an etalon, a prism, or a bandpass filter. In the same manner as the grating, the wavelength change component 41c, which is such a device, changes, by being rotated, the wavelength of the first light L1 entering the first optical system 42.

In the additive manufacturing apparatus 1 in the fourth arrangement, the wavelength change component 41c changes the wavelength of the first light L1 emitted from the first light source 41a. As a result, the wavelength of the first light L1 can be easily changed regardless of the kind of the first light source 41a.

According to at least one arrangement described above, the wavelength of the first light emitted from the first light source is changeable. As a result, the manufactured product having desired performances can be formed by additive manufacturing.

While certain arrangements have been described, these arrangements have been presented by way of example only, and are not intended to limit the scope of the claims. Indeed, the apparatuses described herein may be embodied in a variety of other forms; furthermore various omissions, substitutions and changes in the form of the apparatuses described herein may be made.

Example 1. An additive manufacturing apparatus includes a first irradiation unit, and a first emission device. The first irradiation unit is configured to irradiate a material with first light to melt or sinter the material. The first emission device includes a first light source configured to emit the first light, is configured to cause the first light emitted from the first light source to enter the first irradiation unit, and is capable of changing a wavelength of the first light entering the first irradiation unit.

Example 2. In the additive manufacturing apparatus according to Example 1, the first light source is capable of changing a wavelength of the first light emitted from the first light source. The first emission device further includes a first wavelength changing unit configured to cause the first light source to change the wavelength of the first light.

Example 3. In the additive manufacturing apparatus according to Example 2, the first light source is a quantum cascade laser or an interband cascade laser.

Example 4. In the additive manufacturing apparatus according to Example 1, the first emission device further includes a wavelength change component configured to change a wavelength of the first light emitted from the first light source.

Example 5. The additive manufacturing apparatus according to any one of Examples 1 to 4, further includes a control unit and a storage unit. The control unit is configured to control the first emission device. The storage unit stores therein a function including a peak and obtained from an absorptivity of the material at a wavelength. The control unit is configured to cause the first emission device to change the wavelength of the first light in a wavelength range including a wavelength range corresponding to a half width of the function.

Example 6. The additive manufacturing apparatus according to Example 5, further includes a measurement unit. The measurement unit is configured to irradiate a specimen with the first light emitted from the first emission device, the specimen being made of a material identical to the material, and measure an absorptivity of the material at a wavelength.

Example 7. The additive manufacturing apparatus according to any one of Examples 1 to 6, further includes a supply unit and a neutralization unit. The supply unit is configured to supply the material. The neutralization unit is configured to remove charge from the material supplied by the supply unit.

Example 8. The additive manufacturing apparatus according to any one of Examples 1 to 7, further includes a second irradiation unit, and a second emission device. The second irradiation unit is configured to irradiate a manufactured product formed of the material by additive manufacturing, with second light to remove a part of the manufactured product. The second emission device includes a second light source configured to emit the second light, is configured to cause the second light emitted from the second light source to enter the second irradiation unit, and is capable of changing a wavelength of the second light entering the second irradiation unit.

Example 9. A processing device includes a first irradiation unit, and a first emission device. The first irradiation unit is configured to irradiate an object with first light. The first emission device includes a first light source emitting the first light, is configured to cause the first light emitted from the first light source to enter the first irradiation unit, and is capable of changing a wavelength or a wavelength bandwidth of the first light entering the first irradiation unit.

Example 10. An additive manufacturing method includes: changing a wavelength of first light in a wavelength range including a wavelength range corresponding to a half width of a first function including a peak and obtained from an absorptivity of a material at a wavelength, the first light being emitted from a first light source and having a wavelength bandwidth narrower than the half width of the first function; and irradiating the material with the first light to melt or sinter the material.

Example 11. In the additive manufacturing method according to Example 10, the wavelength range in which the wavelength of the first light is changeable is wider than the half width of the first function.

Example 12. In the additive manufacturing method according to Example 10 or 11, the wavelength of the first light is changed in at least one of two wavelength ranges, one wavelength range being from the shortest wavelength in the first function to a wavelength of an inflection point whose wavelength is the shortest in inflections of a second function obtained by differentiating the first function, the other wavelength range being from a wavelength of an inflection point whose wavelength is the longest in the inflections of the second function to the longest wavelength in the first function.

Example 13. In the additive manufacturing method according to Example 10 or 11, the wavelength of the first light is changed in at least one of two wavelength ranges, one wavelength range being from the shortest wavelength in the first function to a wavelength of an inflection point whose wavelength is the shortest in inflections of a third function obtained by second-order differentiating the first function, the other wavelength range being from a wavelength of an inflection point whose wavelength is the longest in the inflections of the third function to the longest wavelength in the first function.

Example 14. In the additive manufacturing method according to any one of Examples 10 to 13, the material includes a first material and a second material. The shortest wavelength in a wavelength range corresponding to a half width of a fourth function, the fourth function including a peak and being obtained from an absorptivity of the first material at a wavelength, is shorter than the shortest wavelength in a wavelength range corresponding to a half width of a fifth function, the fifth function including a peak and being obtained from an absorptivity of the second material at a wavelength. The longest wavelength in the wavelength range corresponding to the half width of the fourth function is shorter than the longest wavelength in the wavelength range corresponding to the half width of the fifth function. A wavelength bandwidth of the first light is narrower than the half width of the fourth function. The wavelength bandwidth of the first light is narrower than the half width of the fifth function. The wavelength of the first light is changed in a wavelength range including the wavelength range corresponding to the half width of the fourth function and the wavelength range corresponding to the half width of the fifth function.

Example 15. In the additive manufacturing method according to Example 14, the longest wavelength in the wavelength range corresponding to the half width of the fourth function is shorter than the shortest wavelength in the wavelength range corresponding to the half width of the fifth function. The wavelength bandwidth of the first light is narrower than a wavelength range between the longest wavelength in the wavelength range corresponding to the half width of the fourth function and the shortest wavelength in the wavelength range corresponding to the half width of the fifth function.

Example 16. The additive manufacturing method according to Example 14 or 15, further includes supplying the first material and the second material. The wavelength of the first light is changeable faster as compared with a supply rate of the first material and a supply rate of the second material between in the wavelength range corresponding to the half width of the fourth function and in the wavelength range corresponding to the half width of the fifth function.

Example 17. The additive manufacturing method according to any one of Examples 14 to 16, further includes irradiating the solidified second material with laser light having a wavelength outside the wavelength range corresponding to the half width of the fourth function and within the wavelength range corresponding to the half width of the fifth function to melt or evaporate the second material.

Example 18. The additive manufacturing method according to any one of Examples 10 to 17, further includes irradiating a specimen with the first light emitted from the first light source, the specimen being made of a material identical to the material, and measuring an absorptivity of the material for the first light. The wavelength of the first light is changed on the basis of the measured absorptivity.

Example 19. The additive manufacturing method according to any one of Examples 10 to 18, further includes: changing a wavelength of second light that is emitted from a second light source and has a wavelength bandwidth narrower than the half width of the first function, in the wavelength range including the wavelength range corresponding to the half width of the first function; and irradiating a manufactured product formed of the material by additive manufacturing, with the second light emitted from the second light source to remove a part of the manufactured product.

**Claims**

1.  An additive manufacturing apparatus (1) comprising:

    a first irradiation unit (42) configured to irradiate a material (3) with first light (L1) to melt or sinter the material (3); and
    a first emission device (41) that includes a first light source (41a) configured to emit the first light (L1), is configured to cause the first light (L1) emitted from the first light source (41a) to enter the first irradiation unit (42), and is capable of changing a wavelength of the first light (L1) entering the first irradiation unit (42).

2.  The additive manufacturing apparatus (1) according to claim 1, wherein
    the first light source (41a) is capable of changing a wavelength of the first light (L1) emitted from the first light source (41a), and
    the first emission device (41) further includes a first wavelength changing unit (41b) configured to cause the first light source (41a) to change the wavelength of the first light (L1).

3.  The additive manufacturing apparatus (1) according to claim 2, wherein the first light source (41a) is a quantum cascade laser or an interband cascade laser.

4.  The additive manufacturing apparatus (1) according to claim 1, wherein the first emission device (41) further includes a wavelength change component (41c) configured to change a wavelength of the first light (L1) emitted from the first light source (41a).

5.  The additive manufacturing apparatus (1) according to any one of claims 1 to 4, further comprising:

    a control unit (18a) configured to control the first emission device (41); and
    a storage unit (18b) storing therein a function (105) including a peak (106) and obtained from an absorptivity of the material (3) at a wavelength, wherein
    the control unit (18a) is configured to cause the first emission device (41) to change the wavelength of the first light (L1) in a wavelength range including a wavelength range corresponding to a half width (W1; W2) of the function (105).

6.  The additive manufacturing apparatus (1) according to claim 5, further comprising a measurement unit (43) configured to irradiate a specimen (61) with the first light (L1) emitted from the first emission device (41), the specimen (61) being made of a material identical to the material (3), and measure an absorptivity of the material (3) at a wavelength.

7.  The additive manufacturing apparatus (1) according to any one of claims 1 to 6, further comprising:

    a supply unit (31b, 32b) configured to supply the material (3); and
    a neutralization unit configured to remove charge from the material (3) supplied by the supply unit (31b, 32b).

8.  The additive manufacturing apparatus (1) according to any one of claims 1 to 7, further comprising:

    a second irradiation unit (72) configured to irradiate a manufactured product (4) formed of the material (3) by additive manufacturing, with second light (L2) to remove a part of the manufactured product (4); and
    a second emission device (71) that includes a second light source (71a) configured to emit the second light (L2), is configured to cause the second light (L2) emitted from the second light source (71a) to enter the second irradiation unit (72), and is capable of changing a wavelength of the second light (L2) entering the second irradiation unit (72).

9. A processing device comprising:

a first irradiation unit (42) configured to irradiate an object with first light (L1); and
a first emission device (41) that includes a first light source (41a) emitting the first light (L1), is configured to cause the first light (L1) emitted from the first light source (41a) to enter the first irradiation unit (42), and is capable of changing a wavelength or a wavelength bandwidth of the first light (L1) entering the first irradiation unit (42).

10. An additive manufacturing method comprising:

changing a wavelength of first light (L1) in a wavelength range including a wavelength range corresponding to a half width of a first function (105) including a peak (106) and obtained from an absorptivity of a material (3) at a wavelength, the first light (L1) being emitted from a first light source (41a) and having a wavelength bandwidth (W3) narrower than the half width of the first function (105); and
irradiating the material (3) with the first light (L1) to melt or sinter the material (3).

11. The additive manufacturing method according to claim 10, wherein the wavelength range (W5) in which the wavelength of the first light (L1) is changeable is wider than the half width of the first function (105).

12. The additive manufacturing method according to claim 10 or 11, wherein the wavelength of the first light (L1) is changed in at least one of two wavelength ranges, one wavelength range (W6) being from the shortest wavelength in the first function (105) to a wavelength of an inflection point (121a) whose wavelength is the shortest in inflection points (121a, 121b) of a second function (121) obtained by differentiating the first function (105), the other wavelength range (W7) being from a wavelength of an inflection point (121b) whose wavelength is the longest in the inflection points (121a, 121b) of the second function (121) to the longest wavelength in the first function (105).

13. The additive manufacturing method according to claim 10 or 11, wherein the wavelength of the first light (L1) is changed in at least one of two wavelength ranges, one wavelength range (W8) being from the shortest wavelength in the first function (105) to a wavelength of an inflection point (122a) whose wavelength is the shortest in inflection points (122a, 122b, 122c) of a third function (122) obtained by second-order differentiating the first function (105), the other wavelength range (W9) being from a wavelength of an inflection point (122c) whose wavelength is the longest in the inflection points (122a, 122b, 122c) of the third function (122) to the longest wavelength in the first function (105).

14. The additive manufacturing method according to any one of claims 10 to 13, wherein
the material (3) includes a first material (3A) and a second material (3B),
the shortest wavelength in a wavelength range (W1) corresponding to a half width (W1) of a fourth function (105A), the fourth function (105A) including a peak (106) and being obtained from an absorptivity of the first material (3A) at a wavelength, is shorter than the shortest wavelength in a wavelength range (W2) corresponding to a half width (W2) of a fifth function (105B), the fifth function (105B) including a peak (106) and being obtained from an absorptivity of the second material (3B) at a wavelength,
the longest wavelength in the wavelength range (W1) corresponding to the half width (W1) of the fourth function (105A) is shorter than the longest wavelength in the wavelength range (W2) corresponding to the half width (W2) of the fifth function (105B),
a wavelength bandwidth (W3) of the first light (L1) is narrower than the half width (W1) of the fourth function (105A), the wavelength bandwidth (W3) of the first light (L1) is narrower than the half width (W2) of the fifth function (105B), and
the wavelength of the first light (L1) is changed in a wavelength range (W5) including the wavelength range (W1) corresponding to the half width (W1) of the fourth function (105A) and the wavelength range (W2) corresponding to the half width (W2) of the fifth function (105B).

15. The additive manufacturing method according to claim 14, wherein
the longest wavelength in the wavelength range (W1) corresponding to the half width (W1) of the fourth function (105A) is shorter than the shortest wavelength in the wavelength range (W2) corresponding to the half width (W2) of the fifth function (105B), and
the wavelength bandwidth (W3) of the first light (L1) is narrower than a wavelength range (W4) between the longest wavelength in the wavelength range (W1) corresponding to the half width (W1) of the fourth function (105A) and the shortest wavelength in the wavelength range (W2) corresponding to the half width (W2) of the fifth function (105B).

16. The additive manufacturing method according to claim 14 or 15, further comprising supplying the first material (3A) and the second material (3B), wherein the wavelength of the first light (L1) is changeable faster as compared with a supply rate of the first material (3A) and a supply rate of the second material (3B) between in the wavelength range (W1) corresponding to the half width (W1) of the fourth function (105A) and in the wavelength range (W2) corresponding to the half width (W2) of the fifth function (105B).

17. The additive manufacturing method according to any one of claims 14 to 16, further comprising irradiating the solidified second material (3B) with laser light having a wavelength outside the wavelength range (W1) corresponding to the half width (W1) of the fourth function (105A) and within the wavelength range (W2) corresponding to the half width (W2) of the fifth function (105B) to melt or evaporate the second material (3B).

18. The additive manufacturing method according to any one of claims 10 to 17, further comprising irradiating a specimen (61) with the first light (L1) emitted from the first light source (41a), the specimen (61) being made of a material identical to the material (3), and measuring an absorptivity of the material (3) for the first light (L1), wherein
the wavelength of the first light (L1) is changed on the basis of the measured absorptivity.

19. The additive manufacturing method according to any one of claims 10 to 18, further comprising:

changing a wavelength of second light (L2) that is emitted from a second light source (71a) and has a wavelength bandwidth narrower than the half width of the first function (105), in the wavelength range including the wavelength range corresponding to the half width of the first function (105); and
irradiating a manufactured product (4) formed of the material (3) by additive manufacturing, with the second light (L2) emitted from the second light source (71a) to remove a part of the manufactured product (4).

FIG.1

# FIG.2

# FIG.3

# FIG.4

| MATERIAL SUPPLY (LASER LIGHT IRRADIATION) | ANNEALING PROCESSING | SHAPE MEASUREMENT | TRIMMING |

# FIG.5

EP 3 375 549 A1

EP 3 375 549 A1

# FIG.6

# FIG.7

# FIG.8

# FIG.9

4

4b

4c

4a

# FIG.10

START

PRODUCE LIST OF ADJUSTED PEAK
CURVES OF FIRST MATERIAL AND
SECOND MATERIAL — S1

SELECT ONE ADJUSTED PEAK CURVE
OF EACH OF FIRST MATERIAL AND
SECOND MATERIAL — S2

DO
WAVELENGTH REGIONS
OVERLAP WITH EACH
OTHER? — S3

YES

NO

LAMINATE SHAPING USING ADJUSTED
PEAK CURVES — S4

END

# FIG.11

# FIG.12

# FIG.13

Europäisches
Patentamt

European
Patent Office

Office européen
des brevets

# EUROPEAN SEARCH REPORT

Application Number

EP 18 15 8434

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2009/154509 A1 (SUZUKI HIDEYUKI [JP] ET AL) 18 June 2009 (2009-06-18) | 1,2,4-9 | INV. B22F3/105 |
| Y | * claims 1,2,9,12,13; figures 1,14,15 * | 3 | B23K26/00 |
| A | | 10-19 | B29C67/04 C04B35/64 |
| | ----- | | |
| Y | EP 2 924 820 A1 (UNIV KYUSHU NAT UNIV CORP [JP]; GIGAPHOTON INC [JP]) 30 September 2015 (2015-09-30) * claim 4 * | 3 | |
| | ----- | | |
| X | US 2009/207618 A1 (EGAWA AKIRA [JP]) 20 August 2009 (2009-08-20) * claims 1,6 * | 1,2,4,9 | |
| | ----- | | |
| A | US 2003/052105 A1 (NAGANO KAZUHIKO [JP] ET AL) 20 March 2003 (2003-03-20) * the whole document * | 1-19 | |
| | ----- | | |

TECHNICAL FIELDS
SEARCHED      (IPC)

B23K
B22F
B29C
C04B

The present search report has been drawn up for all claims

| Place of search | Date of completion of the search | Examiner |
|---|---|---|
| The Hague | 31 July 2018 | Herbreteau, D |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

 

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 18 15 8434

This annex lists the patent family members relating to the patent documents cited in the above-mentioned European search report.
The members are as contained in the European Patent Office EDP file on
The European Patent Office is in no way liable for these particulars which are merely given for the purpose of information.

31-07-2018

| Patent document cited in search report | | Publication date | Patent family member(s) | | Publication date |
|---|---|---|---|---|---|
| US 2009154509 | A1 | 18-06-2009 | JP 2009142864 A<br>US 2009154509 A1 | | 02-07-2009<br>18-06-2009 |
| EP 2924820 | A1 | 30-09-2015 | EP 2924820 A1<br>JP WO2014080822 A1<br>TW 201433393 A<br>US 2015246848 A1<br>WO 2014080822 A1 | | 30-09-2015<br>05-01-2017<br>01-09-2014<br>03-09-2015<br>30-05-2014 |
| US 2009207618 | A1 | 20-08-2009 | CN 101510039 A<br>JP 2009192873 A<br>US 2009207618 A1 | | 19-08-2009<br>27-08-2009<br>20-08-2009 |
| US 2003052105 | A1 | 20-03-2003 | JP 2003080604 A<br>US 2003052105 A1 | | 19-03-2003<br>20-03-2003 |

EPO FORM P0459

For more details about this annex : see Official Journal of the European Patent Office, No. 12/82